# EUROPEAN PATENT APPLICATION

(11) **EP 0 567 306 A2**
(43) Date of publication of application: **27.10.1993**
(21) Application number: 93303078.5
(22) Date of filing: 21.04.1993
(51) Int. Cl.: H05K 3/46, H05K 3/40

(54) **A multilayer printed circuit board and method for its manufacture**

(30) Priority: 22.04.1992 JP 129637/92
(71) Applicant: Nippon CMK Corp., Iruma-Gun Saitama (JP)
(72) Inventor: Matsumoto, Masuo, c/o Nippon CMK Corporation, Iruma-gun, Saitama (JP); Birukawa, Fusao, c/o Nippon CMK Corporation, Iruma-gun, Saitama (JP); Takahashi, Takazo, c/o Nippon CMK Corporation, Iruma-gun, Saitama (JP)
(74) Representative: Boydell, John Christopher

(57) **Abstract**

There is described a multilayer printed circuit board, and a method of manufacturing same. The manufacturing method comprises forming connection holes in lands on an inner substrate (1), and forming corresponding connection holes in the outer substrates (2, 3). The inner substrate (1) and the outer substrates (2, 3) are adhered to each other with adhesive sheets (8). Then the connection holes are filled with conductive paste (37). The connection holes (15, 16, 24, 25, 30, 31) in the outer substrates (2, 3) have a diameter larger than those of the connection holes (17, 26, 32) in the inner substrate (1) so that the exposed areas of the lands on the inner substrate are enlarged. The lands (12, 20, 28, 33) on the inner substrate (1) have contact with the conductive paste (37) over a large area to enhance conductivity.

## Description

This invention relates to a multilayer printed circuit board and to a method for its manufacture.

In electronic equipment such as data processing machines, electronic business machines or home appliances, in order to require highly integrated signal lines and electromagnetic immunity, a multilayer printed circuit board is widely used.

Figure 13 of the accompanying drawings is an illustration showing a conventional multilayer printed circuit board. Outer substrates 150 are laminated with insulating adhesive sheets 140 on the front and back sides of an inner substrate 100. On both sides of an inner substrate are formed a circuit 110 comprising power lines, ground lines and signal lines as well as lands 120 and 130 for electrical connections. On the outer surface of each outer substrate 150 are formed a circuit 160 and lands 170 and 180 for electrical connections. Blind viaholes 190 are drilled in the land 180. Through the above blind viahole 190, the land 180 of the outer substrate 150 and the land 130 of the inner substrate 100 are electrically connected. Also, the land 170 on the outer substrate 150 and land 120 on the inner substrate 100 are electrically connected by a through-hole 200 which is drilled in these substrates. In order to perform the above electrical connection, plated layers 210 and 220 of conductive material such as copper are formed on the blind viahole 190 and through-hole 200. Solder resist 230 is applied on the upper and lower outer substrates 150.

A method of manufacturing the conventional multilayer printed circuit board is now described. First of all, the circuit 110 and lands 120 and 130 are formed on the inner substrate 100. Then the outer substrate 150 is laminated on the inner substrate 100 through an adhesive sheet which is impregnated with epoxy resin or polyimid resin. The outer substrate 150 is adhered to the inner substrate 100 under high temperature and vacuum conditions. Before this laminating process, the blind viahole 190 has previously been formed in the outer substrate 150. Next, the through-hole 200 is formed through these laminated substrates and the conductive material is plated. By the foregoing steps, the inner surfaces of the blind viahole 190 and through-hole 200 are coated with the plated layers 210 and 220. The circuit 160 and lands 170, 180 are formed by performing pattern treatment to the copper film on the outer surface of the outer substrate 150. Then the solder resist 230 is applied to make the multilayer printed circuit board.

In the conventional multilayer printed circuit board, the plated layers 210 and 220 are formed on the inner surfaces of the through-hole 200 and blind viahole 190 to connect the lands electrically. The above plating process is cumbersome and time- consuming , and detrimental to speedy manufacturing.

Moreover, these plated layers 210 and 220 are in contact with the lands 120, 170 and 180 only at the internal circumferential area of the lands 120,170 and 180. This results in a small contact area and poor reliability of conductivity.

The present invention seeks to provide a multilayer printed circuit board and a method for its manufacture which improves the reliability of conductivity between lands without the cumbersome plating process.

In order to achieve this, the multilayer printed circuit board according to this invention includes connection holes in the outer substrates which have larg- erdiameters than those of the connection holes in the inner substrates. The lands of the inner and outer substrates are electrically connected to each other by conductive paste filled in the connection holes formed in both substrates.

A first embodiment of the manufacturing method for the multilayer printed circuit board comprises the steps of: forming connection holes in the lands on the inner substrate, forming connection holes of diameters larger than those of the above connection holes in the lands on the outer substrates, laminating the inner and outer substrates to connect connection holes of both substrates through an adhesive sheet which has holes of larger diameters than those of the above connection holes in the portion corresponding to the above connection holes of the inner substrate, and filling the connection holes with conductive paste.

A second embodiment of the manufacturing method according to this invention comprises the steps of: laminating the outer substrates on the inner substrate where lands are formed, forming through-holes , which go through the laminated board, in the lands of the above inner substrate, forming lands on the outer substrates and then forming connection holes to remove the insulating layers of the outer substrates inside of the above lands and to expose the lands on the inner substrate, and fitting these connection holes with conductive paste.

In the above constructed multilayer printed circuit board, the lands of the inner substrate and those of the outer substrates are electrically connected through the connection holes filled with conductive paste, which requires no plating. The lands on the inner substrate are exposed by the difference in the diameters of the connection holes because the diameters of the connection holes in the outer substrate are larger than those of the connection holes in the inner substrate. Therefore, the lands of the inner substrate have contact with the conductive paste at not only their internal circumferential areas but also the exposed areas, resulting in larger contact areas and more reliable conductivity.

The foregoing manufacturing method offers more reliable multilayer printed circuit boards quickly without fail, because the inner and outer substrates are laminated after forming the connection holes in each of the above inner and outer substrates.

Moreover, a multilayer printed circuit board with more reliable conductivity can also be manufactured by the method that the lands on the inner substrate are exposed afterthe removal of the insulating layers inside of the lands on the outer substrates which are laminated on the inner substrate.

In order that the invention may be better understood, several embodiments thereof will now be described by way of example only and with reference to the accompanying drawings in which:-
Figure 1 is a flow chart of the manufacturing processes of a first embodiment of the invention;
Figure 2 is a sectional view of the substrates before they are laminated in the first embodiment;
Figure 3 is a sectional view of a multilayer printed circuit board according to the first embodiment;
Figure 4 is a sectional view of a multilayer printed circuit board according to a second embodiment of the invention;
Figure 5 is a partial sectional view of a multilayer printed circuit board according to a third embodiment of the invention;
Figure 6 is a sectional view of a substrate in a manufacturing process of a fourth embodiment of the invention;
Figure 7 is a sectional view of a multilayer printed circuit board in another manufacturing process of the fourth embodiment;
Figure 8 is a sectional view of a circuit board in still another manufacturing process of the fourth embodiment;
Figure 9 is a sectional view of a circuit board in still another manufacturing process of the fourth embodiment;
Figure 10 is a sectional view of a circuit board in still another manufacturing process of the fourth embodiment;
Figure 11 is a sectional view of a circuit board in still another manufacturing process of the fourth embodiment;
Figure 12 is a sectional view of a circuit board in still another manufacturing process of the fourth embodiment;
Figure 13 is an illustration showing a conventional multilayer printed circuit board.

In each of the embodiments to be described, corresponding components are given the same reference numerals, so overlapping explanation is omitted.

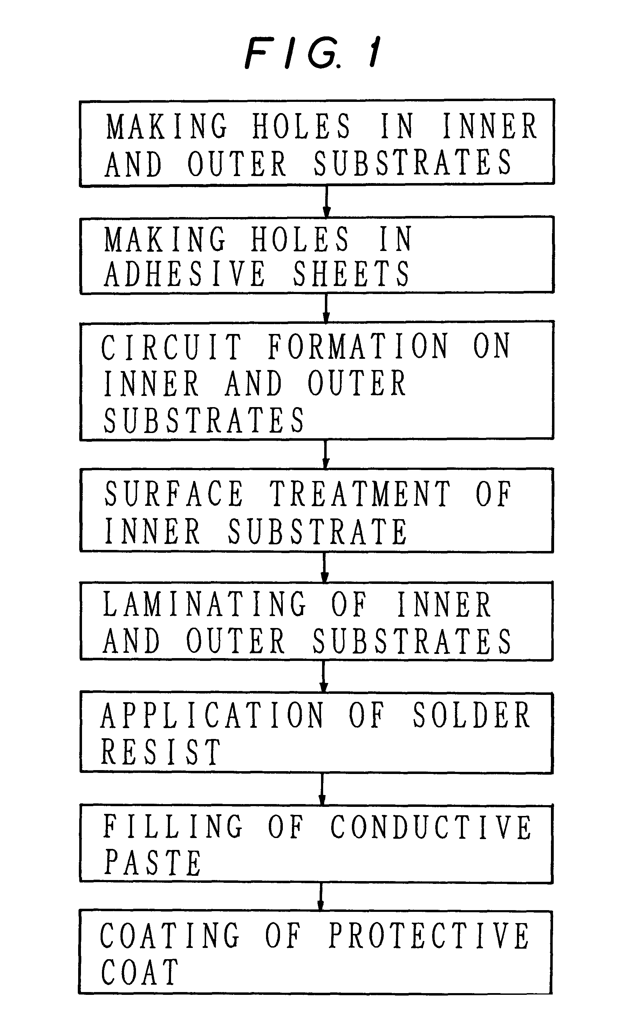

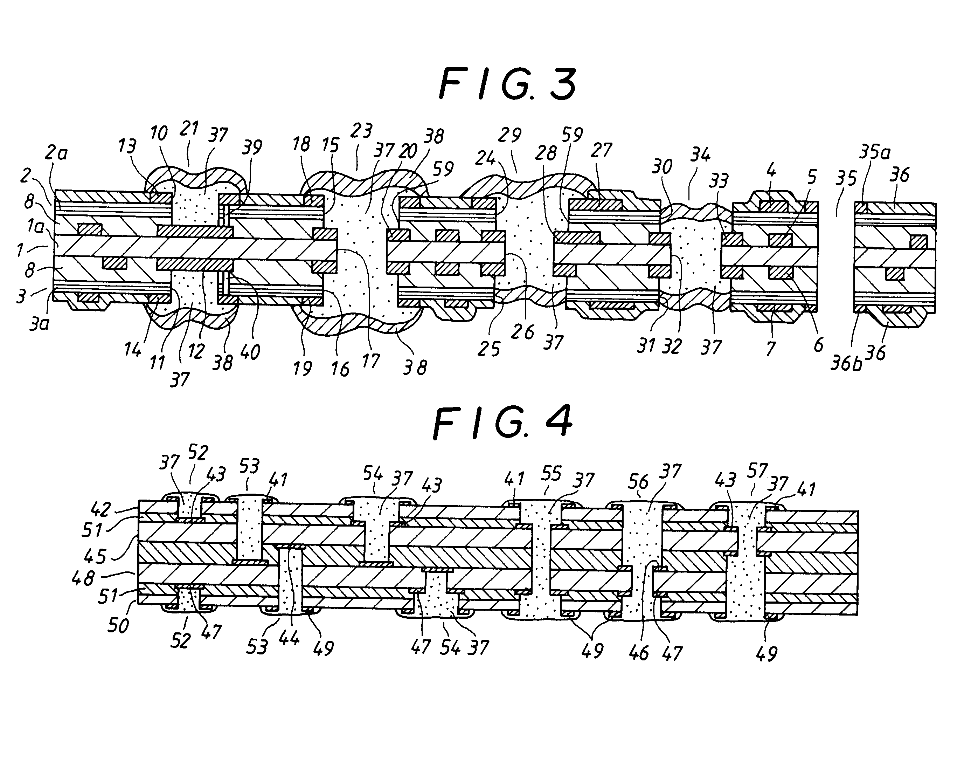

In the embodiment of Figures 1, and 3, an outer substrate 2 is laminated on the upper side of an inner substrate 1 and an outer substrate 3 is laminated on the lower side of the inner substrate 1. A circuit 4 on the upper substrate 2 is the first conductor, a circuit 5 on the upper side of the inner substrate 1 is the second conductor, a circuit 6 on the lower side of the inner substrate 1 is the third conductor, and a circuit 7 on the lower outer substrate 3 is the fourth h conductor. Thus, the circuit board has a four-layered construction.

The inner substrate 1 comprises an insulating layer 1 a and copper layers applied on both sides of the insulating layer 1a. The outer substrates 2 and 3 comprise insulating layers 2a, 3a and copper layers applied on one side of each of the insulating layers 2a and 3a.

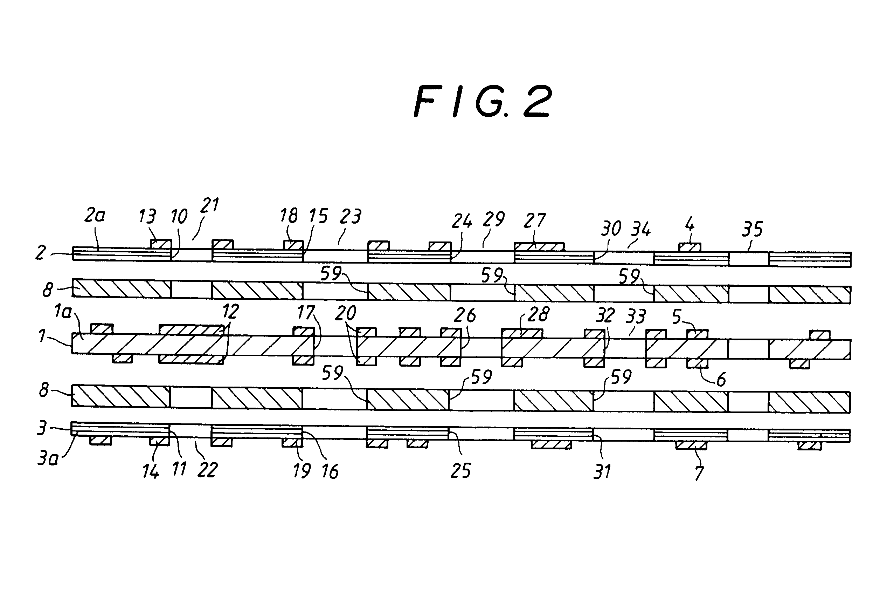

First of all, as shown in Figures 1 and 2, to make holes, these copper-layer laminated boards are drilled and an adhesive sheet 8 inserted between the copper-layer laminated boards is punched. As shown in Figure 3, the above drilling and punching steps are for forming connection holes such as through-holes, blind viaholes and interstitial viaholes. The connection holes are formed in each copper-layer laminated board so that the corresponding holes communicate with one another.

As shown in Figure 2, a connection hole 10 formed in the upper layer of the outer substrate 2 is a blind viahole 21, and a connection hole 11 formed in the lower layer of the outer substrate 3 is also a blind viahole 22. These viaholes 21 and 22 connect the land 12 on the inner substrate 1, the land 13 on the outer substrate 2, and the land 14 on the outer substrate 3. The connection hole 15 in the outer substrate 2, connection hole 16 in the outer substrate 3 and connection hole 17 in the inner substrate 1 comprise a through-hole 23 which connects the land 18 on the outer substrate 2, the land 19 on the outer substrate 3 and the land 20 on the inner substrate 1. A connection hole 24 in the outer substrate 2, a connection hole 25 in the outer substrate 3 and a connection hole 26 in the inner substrate 1 comprise a through-hole 29 which connects a land 27 on the upper outer substrate 2 and a land 28 on the inner substrate 1. A connection hole 30 in the outer substrate 2, a connection hole 31 in the outer substrate 3 and connection hole 32 in the inner substrate 1 comprise an interstitial viahole 34 which connects lands 33 on the front and backsides of the inner substrate 1. Anon-through-hole 35 in Figure 3 does not electrically connect the substrates of the four-layered circuit board.

In this embodiment, around the above non-through-hole 35, a land 35a exists on the outer substrate 2 and a land 35b exists on the outer substrate 3. In mounting electronic components, a conductor may be inserted into the non-through-hole 35 and then the lands 35a and 35b may be soldered to the conductor to electrically connect the lands 35a and 35b. Electric connection with a conductor and soldering may also be applied to the through-holes 23, 29 and interstitial viahole 34.

In the foregoing connection holes and the diameters of the through-hole 23, 29 and interstitial viahole 34, the connection holes 15, 16, 24, 25, 30 and 31 of the outer substrate 2 and 3 have larger diameters than those of the connection holes 17, 26 and 32 of the inner substrate 1. Holes 59 in the adhesive sheet 8 corresponding to the through-holes 23, 29 and interstitial viahole 34 have larger diameters than those of the connection holes 17, 26 and 32.

After the above drilling and punching step of the inner substrate 1 and the outer substrates 2 and 3, the copper film on the inner substrate 1 is etched to form the circuits 4, 5, 6 and 7 and lands 12, 13, 14, 18, 19, 20,27,28 and 33. The hole diameters of the lands 20, 28 and 33 in the inner substrate 1 of the through-hole 23 and 29 and interstitial viahole 34 are small so that those lands 20, 28 and 33 extend into the connection holes 15, 16, 24, 25, 30 and 31 of the outer substrates 2,3.

After the foregoing manufacturing steps of the circuits and lands, the surfaces of the circuits 5, 6 and lands 12, 20, 28 and 33 on the front and back sides of the inner substrate 1 are black treated with such as melanism in order to increase adherence strength, and the outer substrates 2, 3 are laminated on the inner substrate 1. In this laminating step, the inner substrate 1 and outer substrates 2, 3 as well as the adhesive sheet 8 having holes 59 are aligned in their respective positions so that the corresponding connection holes communicate with each other. Then, by means of press-laminating or roll-laminating, the outer substrate 2 is adhered to the front side of the inner substrate 1 and the outer substrate 3 is adhered to the back side of the inner substrate 1.

Then solder resist 36 is applied onto the surfaces of the outer substrates 2, 3. The blind viaholes 21,22, through-holes 23, 29 and interstitial viahole 34 are filled with conductive paste 37 such as copper paste or silver paste. The exposed portion of the conductive paste 37 is coated with a protective coat 38 to produce a multilayer printed circuit board as shown in Figure 3.

The above-mentioned conductive paste 37 electrically connects the corresponding lands on the inner substrate 1 and outer substrates 2 and 3. In such multilayer printed circuit board, the diameter of connection hole 17 in the inner substrate 1 is smaller than that of the connection holes 15, 16 in the outer substrates, the diameter of connection hole 26 is smaller than that of the connection holes 24, 25 in the outer substrates and the diameter of connection hole 32 is smaller than that of connection hole 30, 31 in the outer substrate. Therefore, the land 20 in connection hole 17, land 28 in connection hole 26 and land 33 in connection hole 32, are all formed on the substrate 1, and are exposed into the connection holes in the outer substrates. Therefore, the conductive paste 37 has contact with not only the internal circumferential area but also the exposed portions of the lands 20, 28 and 33, which increases the contact areas, and a multilayer printed circuit board with more reliable conductivity can be produced.

From the first conductor side, that is, the side of the upper outer substrate 2, the conductive paste 38 is filled into the blind viahole 21 which is not a through-hole. From the fourth conductor side, that is, the side of lower outer substrate 3, the conductor paste 38 is filled into the blind viahole 22.

As shown in Figures 2 and 3, a small-diameter air passage hole 39 is formed near the blind viahole 21, and a small-diameter air passage hole 40 is formed near the blind viahole 22. The air passage hole 39 is formed through the substrate 2 and the air passage hole 40 is formed through the substrate 3. These air passage holes allow air in viaholes 21, 22 to leak out when the blind viaholes 21, 22 are filled with the conductive paste 38. Forthis reason, though the viaholes 21, 22 have no open holes, air bubbles do not remain inside the holes and the conductive paste can be filled without fail, resulting in higher reliability.

In the above embodiment, the inner substrate 1 and outer substrates 2, 3 are laminated after the step of forming the circuits and lands on these substrates. However, a multilayer printed circuit board may also be produced by the following processes:-First of all, circuits and lands are formed only on the inner substrate 1;

Then, two substrates, each of which has a single-sided copper laminated layer thereof, are laminated on both sides of the substrate 1 with the copper layers outwards;

After the above steps, the outer copper layers on both sides of the above laminated substrate are etched to form circuits and lands. Then a multilayer printed circuit board can be produced.

Figure 4 shows a six-layer printed circuit board according to a second embodiment of the invention. In the second embodiment, the first conductor42 has formed thereon a land 41 as the first conductor. The first inner substrate 45 has a land 43 as the second conductor and a land 44 as the third conductor on both sides thereof. The second inner substrate 48 has a land 46 as the fourth conductor and a land 47 as the fifth conductor on both sides. The second outer substrate 50 has a land 49 as the sixth conductor on one side thereof. The first outer substrate 42, first inner substrate 45, second inner substrate 48, and second outer substrate 50 are laminated through adhesive layers 51.

In the above printed circuit board, blind viaholes 52, 53 and 54, and through-holes 55, 56 and 57 are formed and lands are connected electrically through the through-holes filled with conductive paste 37. The connection holes, that is, blind viahole 54 and through-holes 55,56 and 57 in the outer substrate 42, 50, have a diameter larger than those of the connection holes in the outer substrate 42, 50. For this reason, lands 43, 44 on the inner substrate 45 and lands 46,47 on the inner substrate 48 have a large exposed area, which results in more reliable conductivity with the large contact area with conductive paste 37.

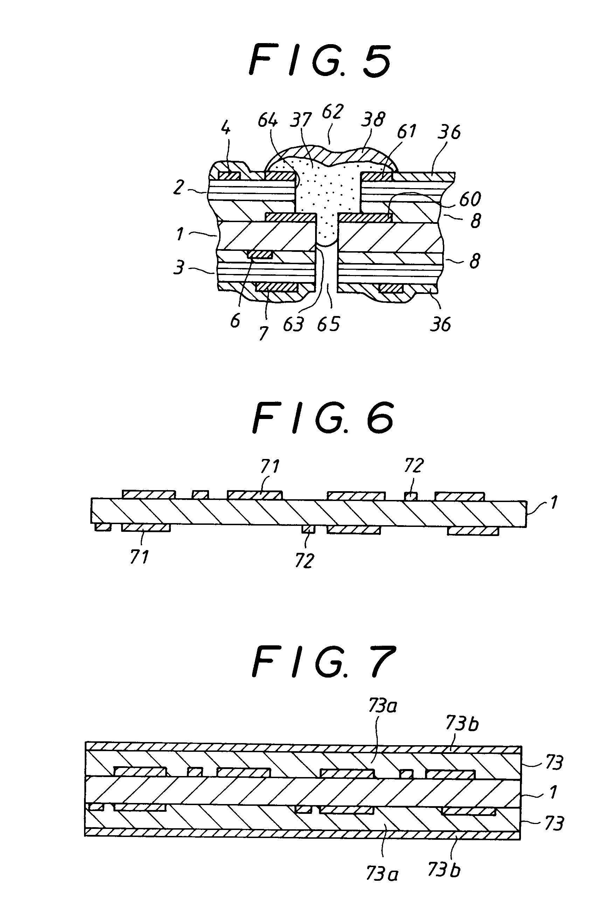

Figure 5 shows a partial circuit board according to a third embodiment of the invention. In the third embodiment, a land 60 on the inner substrate 1 and a land 61 on the outer substrate 2 are connected through a blind viahole 62. Aconnection hole 64 in the outer substrate 2 has a diameter larger than that of a connection hole 63 in the inner substrate 1. The exposed area of the land 60 on the inner substrate 1 is large.

A through-hole 65 which communicates with the connection hole 63 in the inner substrate 1 is formed through the lower outer substrate 3. The blind viahole 62 is filled with conductive paste 37 to electrically connect the land 60 on the inner substrate 1 and the land 61 on the upper outer substrate 2. The through-hole 65 formed in the lower outer substrate 3 works as an air passage hole during filling of the conductive paste 37.

Therefore, the conductive paste 37 can be smoothly filled into the blind viahole 62. The lands 60, 61 can be electrically connected without fail.

Figures 6 to 12 show the manufacturing processes of a fourth embodiment of the invention.

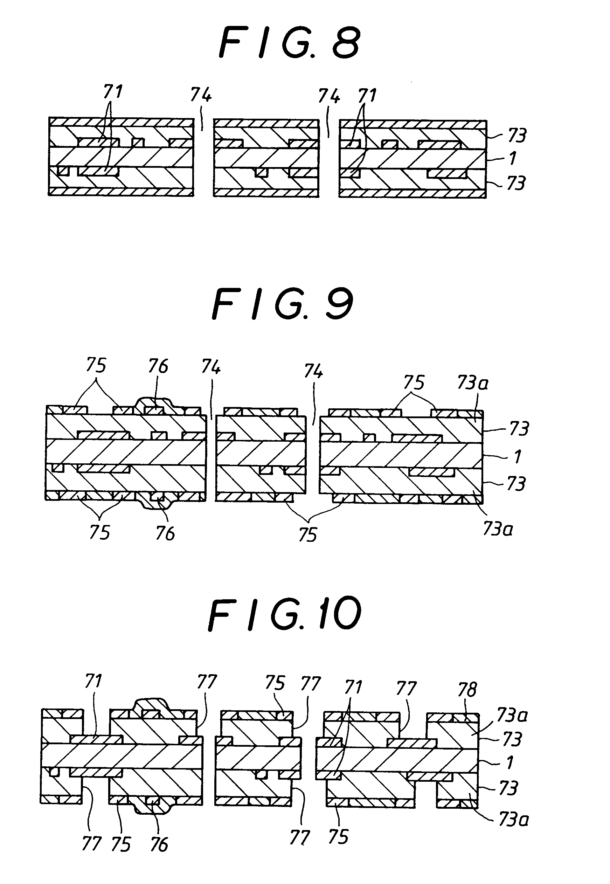

First, both sides of a copper-layer laminated board are etched to produce the inner substrate 1 on both sides of which the land 71 and circuit 72 are pattern-formed (Figure 6). The surfaces of land 71 and circuit 72 are treated to increase adherence strength. Then, single sided copper-layer laminated boards 73 are applied on both sides of the above inner substrate 1 (Figure 7). This single sided copper-layer laminated board 73 is composed of an insulating layer 73a and copper film 73b with which insulating layer 73a is coated. The above lamination may be performed by inserting adhesive sheets, by printing adhesive paste, or by laminating adhesive agent. After this lamination, a through-hole 74 is formed (Figure 8), and the copper films 73b on the single sided copper-layer laminated boards 73 are etched and land 75 and circuit 76 are pattern-formed to produce an outer substrate 73. Then, solder resist 78 is printed on a surface of both outersubstrates 73 (Figure 9). Aremovable resist may be used as the solder resist 78 for the next process.

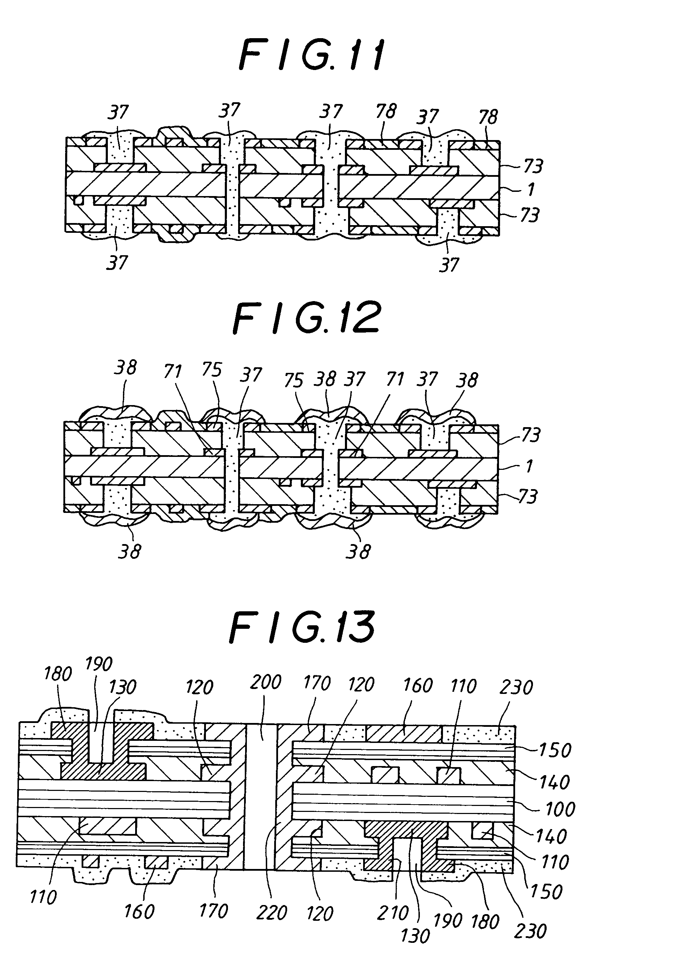

Moreover, the insulating layer 73a is removed from the outer substrate 73 which is disposed inside of the land 75 (Figure 10). This removal of the insulating layer 73a can be performed by chemical dissolution or laser irradiation to reach the land 71 on the inner substrate 1.

The insulating layer 73a is removed so that the diameter of a connection hole 77 of the above through-hole 74 is larger than that of the through-hole 74. Forming the connection hole 77 of a larger diameter enlarges the exposed area of the land 71 on the inner substrate 1.

After removal of the insulating layer 73a from the outer substrate 73, the connection hole 77 in the outer substrate 73 is filled with conductive paste 37 by printing (Figure 11), and the exposed surface of the conductive paste 37 is coated with the protective coat 38 by printing (Figure 12).

By following the above manufacturing method of this embodiment, the land 71 on the inner substrate 1 and the land 75 on the outer substrate 73 can be electrically connected through the through-holes and blind viaholes. At the through-holes, the exposed areas of the lands 71 on the inner substrate 1 become larger to enlarge the contact area with the conductive paste 37, which results in more reliable connection.

In this embodiment, the through-holes may be formed between the lands 71 on both sides of the inner substrate 1 before the lands 71 are electrically connected through the conductive paste, plating or other equivalents before proceeding to the following process.

As mentioned above, the multilayer printed circuit board according to the invention can increase the reliability of conductivity because the lands on the inner substrate and the conductive paste are in contactwith one another over a large area and the manufacturing methods of the invention produce the above multilayer printed circuit board easily without fail.

## Claims

1. A multilayer printed circuit board, comprising:-
an inner substrate having a land and a connection hole; and
an outer substrate having a land and a connection hole communicating with the connection hole of said inner substrate, the connection holes of said inner and outer substrates being filled with conductive paste to communicate the lands on said inner and outer substrates with each other,
wherein the diameter of the connection hole of said outer substrate is larger than that of the connection hole of said inner substrate.

2. A multilayer printed circuit board as claimed in claim 1, further comprising an air passage hole for allowing air inside the board to leak out during filling with said conductive paste.

3. A method of manufacturing a multilayer printed circuit board, said method comprising the steps of:-
(a) forming a connection hole through a land on an inner substrate, forming a connection hole through a land on an outer substrate, the diameter of which latter is larger than that of the connection hole through said inner substrate;
(b) laminating said inner and outer substrates through an adhesive sheet provided with a hole on the portion facing the connection hole of said inner substrate to communicate said connection hole of said inner substrate with said connection hole of said outer substrate, said hole of said adhesive sheet being larger than that of the connection hole of said inner substrate; and
(c) filling said connection holes communicating with each other with conductive paste.

4. A method of manufacturing a multilayer printed circuit board, said method comprising the steps of:-
(a) laminating an outer substrate on an inner substrate provided with a land thereon;
(b) forming a connection hole near said land and through said inner substrate;
(c) forming a land on said outer substrate and a connection hole by removing the insulating layer inside the land on said outer substrate to expose the land on said inner substrate; and
(d) filling said connection holes with conductive paste.

5. A method as claimed in either one of claims 3 or 4, wherein said connection holes are filled with conductive paste before being filled with solder material.
